# EUROPÄISCHE PATENTSCHRIFT

(11) **EP 0 948 752 B1**
(45) Veröffentlichungstag und Bekanntmachung des Hinweises auf die Patenterteilung: **10.10.2001**
(21) Anmeldenummer: 97949924.1
(22) Anmeldetag: 14.11.1997
(51) Int. Cl.: G02B 6/12, G02B 6/42

(54) **OPTOELEKTRONISCHER MODUL**
OPTOELECTRONIC MODULE
MODULE OPTOELECTRONIQUE

(30) Priorität: 17.12.1996 DE 19652533
(43) Veröffentlichungstag der Anmeldung: 13.10.1999
(73) Patentinhaber: Infineon Technologies AG, 81669 München (DE)
(72) Erfinder: STEGMÜLLER, Bernhard, D-86163 Augsburg (DE)
(74) Vertreter: Zedlitz, Peter, Dipl.-Inf.
(86) Internationale Anmeldenummer: DE9702672
(87) Internationale Veröffentlichungsnummer: WO9827449

(56) Entgegenhaltungen:
- EP-A- 0 569 181
- EP-A- 0 591 864
- EP-A- 0 616 234
- EP-A- 0 696 747
- US-A- 3 879 606

## Beschreibung

Die vorliegende Erfindung betrifft einen optoelektronischen Modul zur Integration von aktiven elektrooptischen Komponenten und passiven Wellenleitern zur optischen Kopplung an externe Wellenleiter.

Die optische Kopplung zwischen optoelektronischen Komponenten bestimmt wesentlich die Eigenschaften von optoelektronischen Systemen bzw. das Zusammenwirken dieser Komponenten mit daran angeschlossenen Übertragungsmedien wie z. B. Glasfasern. Die optische Kopplung sollte möglichst effektiv sein bei einfacher und kostengünstiger technischer Realisierung. Bei optoelektronischen Komponenten mit sehr kleinen Abmessungen (unter 100 µm) ist eine monolithische Integration mit Wellenleitern auf Substraten mit größeren Ausmaßen notwendig, da eine mechanische Behandlung (Transport bzw. Montage) solcher einzelner Mikrostrukturelemente nur sehr schwierig oder sogar unmöglich ist. Zu einer derartigen optischen Kopplung von aktiven Komponenten und passiven Wellenleitern wurden z. B. in der Veröffentlichung von T. Ido e.a.: "High-Speed MQW Electroabsorption Optical Modulators Integrated with Low-Loss Waveguides" in IEEE Photonics Technology Letters, 7, 170 bis 172 (1995) und in der Veröffentlichung von R. Ben-Michael e.a.:"A Bi-Directional Transceiver PIC for Ping-Pong Local Loop Configurations Operating at 1.3-µm Wavelength" in IEEE Photonics Technology Letters, 7, 1424 bis 1426 (1995) Anordnungen vorgeschlagen, bei denen die aktiven und die passiven Komponenten in demselben Materialsystem hergestellt werden. Auch der Einbau von adiabatischen Tapern (sich in eine Richtung verjüngende Abschnitte eines Wellenleiters) erfolgt unter Verwendung derselben Materialkomponenten. Der Nachteil dabei ist, daß die Herstellungsverfahren derartiger Anordnungen sehr aufwendig sind. Sie erfordern insbesondere mehrfache Epitaxieschritte und einen erheblichen Verbrauch der Halbleitermaterialien.

In der EP 0 569 181 A1 ist eine integrierte optische Anordnung beschrieben, bei der mittels einer integrierten und sich aufweitenden Linse eine Ankopplung eines optoelektronischen Bauelementes mit asymmetrischem Modenausgang an eine externe Glasfaser bewirkt ist. Während das optische Bauelement aus Halbleitermaterial besteht, ist die Linse ein Polymerfilm auf einer dielektrischen Deckschicht.

Aufgabe der vorliegenden Erfindung ist es, einen optoelektronischen Modul anzugeben, in dem aktive und passive Komponenten integriert sind und der einfache Herstellung und Handhabung ermöglicht.

Diese Aufgabe wird mit dem Modul mit den Merkmalen des Anspruches 1 gelöst. Weitere Ausgestaltungen ergeben sich aus den abhängigen Ansprüchen.

Bei dem erfindungsgemäßen Modul werden die optoelektronischen Bauelemente, die als aktive Komponenten fungieren, als auf ein Substrat epitaktisch gewachsene Schichtfolge ausgebildet. Das epitaktische Wachstum kann lokal begrenzt erfolgen. Statt dessen kann eine ganzflächige Schichtfolge aufgebracht und anschließend örtlich begrenzt rückgeätzt werden. In den freien Bereichen der Substratoberfläche sind passive Wellenleiter angeordnet, die die aktiven Zonen der Bauelemente mit äußeren Anschlußflächen verbinden, an die z. B. eine Glasfaser angeschlossen werden kann. Wesentlich für den erfindungsgemäßen Modul ist es, daß die passiven Wellenleiter aus einem Material bestehen, das nicht zu dem Materialsystem gehört, das für die aktiven Komponenten verwendet wird.

Der erfindungsgemäße Modul hat den Vorteil, daß grundsätzlich alle Materialsysteme verwendet werden können, die bisher für optoelektronische Einzelbauelemente verwendet werden (z.B. verschiedene Zusammensetzungen von InGaAsP, InGaAlAs, GaN, InGaALP usw.). Die für die aktiven Bauelemente erforderlichen Schichtstrukturen werden auf den für das betreffende Materialsystem üblichen Substraten aufgewachsen, wobei ein Substrat relativ großer Abmessung gewählt werden kann. Die Schichtfolgen werden seitlich begrenzt aufgewachsen oder rückgeätzt, so daß die aktiven Bauelemente jeweils nur einen geringen Anteil der Substratoberfläche einnehmen. Diese aktiven Komponenten enthalten üblicherweise einen optischen Wellenleiter, der z. B. durch die aktive Schicht einer Laserdiode oder dergleichen gebildet sein kann. Bei einer Anordnung des Bauelementes im Innern der Substratoberfläche reicht dieser optische Wellenleiter des Bauelementes nicht bis an den Rand des Substrates und kann daher nicht unmittelbar an externe Wellenleiter angeschlossen werden. Ein solcher Anschluß an externe Wellenleiter kann auch bei einem am Rand der Substratoberfläche angeordneten Bauelement dadurch erschwert sein, daß der für den Anschluß vorgesehene Bereich des in dem Bauelement vorhandenen Wellenleiters zu schmal ist für einen wirkungsvollen Übergang in ein äußeres wellenleitendes Medium. Es wird daher erfindungsgemäß ein passiver Wellenleiter vorgesehen, der die Verbindung des in dem aktiven Bauelement vorhandenen Wellenleiters mit einer Anschlußfläche nach außen herstellt. Dieser passive Wellenleiter kann insbesondere so ausgebildet sein, daß er relativ niedrig und schmal an das aktive Bauelement anschließt und mit zunehmender Entfernung von dem Bauelement sich in der Ebene der Substratoberseite und/oder senkrecht dazu zunehmend verbreitert und so eine Art Taper bildet, der die schmale Wellenleiterzone in dem Bauelement mit einer demgegenüber deutlich vergrößerten Anschlußflache am Rand des Moduls verbindet. Es können an ein aktives Bauelement mehrere Wellenleiter angeschlossen sein. Insbesondere kann z. B. bei einer Laserdiode an beide Resonatorendflächen je ein Wellenleiter angeschlossen sein. Zusätzlich können Wellenleiter quer zu dieser Längsrichtung der Laserdiode an die aktive Zone angeschlossen sein, z. B. um die in Längsrichtung der Laserdiode erfolgende Strahlungsausbreitung steuern zu können.

Zur Herstellung der optoelektronischen Komponenten können Epitaxieprozesse eingesetzt werden wie z. B. MOVPE (metallo-organic vapor phase epitaxy), MBE (molecular beam epitaxy) oder MOMBE (metallo-organic molecular beam epitaxy). Die aktiven Komponenten werden seitlich z. B. dadurch begrenzt, daß die Schichten rückgeätzt werden. Dafür können die üblichen Ätztechniken eingesetzt werden. Die Bauelemente werden mit einer Maske abgedeckt, und das Material in dem nicht abgedeckten Bereich wird durch Ätzen abgetragen. Mögliche Verfahren, die dafür zum Einsatz kommen können, sind z. B. IBE (ion beam etching), RIE (reactive ion beam etching), FIBE (focused ion beam etching), RIPE (resonant induced plasma etching), CAIBE (chemical assisted ion beam etching). Statt ganzflächig aufzuwachsen und danach lokal rückzuätzen ist es möglich, durch selektive Epitaxie örtlich begrenzt Schichtfolgen aufzuwachsen, dafür können auch wieder MOMBE oder MOVPE eingesetzt werden.

Die passiven Wellenleiter werden in ergänzenden Verfahrensschritten hergestellt. Erfindungsgemäß werden dafür Materialien verwendet, die keine Komponente der für die aktiven Bauelemente verwendeten Halbleitermaterialien enthalten. Die passiven Wellenleiter gehören daher nicht zu dem für die aktiven Komponenten verwendeten Materialsystem. Das gilt auch dann, wenn die aktiven Komponenten in dem Modul aus verschiedenen Materialsystemen hergestellt werden. Das Material der passiven Wellenleiter ist grundsätzlich davon verschieden. Für die passiven Wellenleiter können grundsätzlich alle Materialien verwendet werden, die für die darin zu führende Strahlung durchlässig sind. Vorzugsweise kommen Polyimide, Bisbenzocyclobuten, Silizium und/oder Siliziumdioxid und andere für Betriebswellenlänge transparente Dielektrika oder Materialien in Frage. Zur Strukturierung dieser passiven Wellenleiter werden vorzugsweise bei der Herstellung Masken- und Ätztechniken eingesetzt, die jeweils von dem verwendeten Material abhängen und an sich bekannt sind. Speziell können verwendet werden IBE, RIE, FIBE und RCE (resonant cyclotron etching). Die Dicke der Wellenleiter kann so gewählt sein (typisch < 10 µm), daß auch Taperstrukturen sowohl in der Ebene der Substratoberseite als auch senkrecht dazu (parallel bzw. senkrecht zur Wachstumsrichtung beim Aufwachsen des Materials) hergestellt werden können. Derartige Taperstrukturen aus passivem Material lassen sich einfacher und kostengünstiger herstellen als bei Verwendung von Halbleitermaterial, wie es für die aktiven Komponenten verwendet wird.

Zum Zweck der Wellenführung in Richtung senkrecht zur Substratoberseite kann zwischen das Substratmaterial und den passiven Wellenleiter eine reflektierende Schicht eingefügt werden, die z. B. Metall (Gold, Silber), Silizium oder ein Dielektrikum sein kann. Diese Schicht kann auch durch eine Schichtstruktur aus mehreren Lagen gebildet werden. Verwendbar sind dafür dielektrische Materialien wie z. B. Al₂O₃, SiOₓ oder SiNₓ/Si. Als Substratmaterial kommen InP, GaAs, GaP, GaN oder LiNbO₃ in Frage.

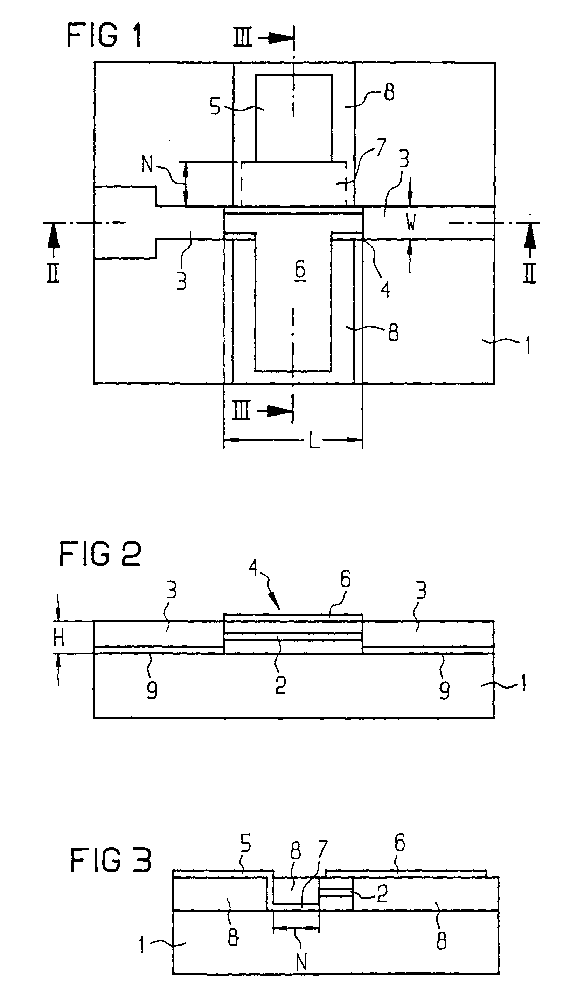

Es folgt eine genauere Beschreibung verschiedener Ausführungsbeispiele eines Moduls anhand der Figuren 1 bis 14.
Figuren 1, 4, 7, 8, 11 und 14 zeigen verschiedene Ausführungsformen des Moduls in Aufsicht.
Die übrigen Figuren zeigen jeweils die in den genannten Figuren eingezeichneten Querschnitte.

Bei der in Figur 1 dargestellten Anordnung befindet sich auf der Oberseite eines Substrates 1 ein aktives Bauelement 4. In Längsrichtung dieses Bauelementes schließen sich passive Wellenleiter 3 an. Für Strominjektion vorgesehene Kontakte 5, 6 sind seitlich zu dieser Längsrichtung zugeführt. In dem dargestellten Beispiel ist der eine Kontakt 5 auf einer Schicht aus Dielektrikum 8 aufgebracht und angrenzend an das Bauelement 4 auf die Substratoberseite heruntergeführt. Der untere Anteil 7 des Kontaktes 5, kann mit dem Dielektrikum 8 bedeckt sein und ist daher in Figur 1 als verdeckte Kontur gestrichelt eingezeichnet. Ein zweiter Kontakt 6 befindet sich ebenfalls auf einer Schicht aus Dielektrikum 8 und ist auf die Oberseite des Bauelementes 4 geführt.

Figur 2 zeigt den in Figur 1 eingezeichneten Querschnitt. Auf dem Substrat 1 befindet sich das Bauelement 4 mit einer Wellenleiterschicht 2, die z. B. die aktive Schicht eines lichterzeugenden Bauelementes sein kann. Der Kontakt 6 auf der Oberseite ist in diesem Beispiel auf der gesamten Länge des Bauelementes 4 vorhanden. In Längsrichtung des Bauelementes schließen sich beidseitig Wellenleiter 3 an, die in diesem Beispiel durch eine die Wellenführung verbessernde Schicht 9 von dem Substrat 1 getrennt sind. Diese Schicht 9 kann auch weggelassen sein. Figur 3 zeigt den anderen in Figur 1 eingezeichneten Querschnitt quer zur Längsrichtung des Bauelementes. In Figur 3 sind daher beide Kontakte 5, 6 erkennbar. Der Kontakt 5 ist in einer Stufe auf die Oberseite des Substrates 1 heruntergeführt. Der untere Anteil 7 des Kontaktes 5 ist bis zu einer unteren Schicht des Bauelementes geführt, so daß an das Bauelement Strom angelegt werden kann.

Typische Abmessungen bei dieser Anordnung sind z. B. wie folgt:
Länge L des Bauelementes zwischen 1 µm und 600 µm,
Breite W des Bauelementes zwischen 0,1 µm und 40 µm,
Abmessung N des unteren Anteils 7 des Kontaktes 5 etwa zwischen 10 µm und 20 µm und
Höhe H des Bauelementes zwischen 2 µm und 10 µm.
Der passive Wellenleiter 3 hat vorzugsweise die seitliche Abmessung des Bauelementes, besitzt also ebenfalls die Breite W. Der Wellenleiter, der in Figur 1 auf der linken Seite eingezeichnet ist, ist dort als Beispiel mit einer abrupten Verbreiterung dargestellt. Eine derartige Verbreiterung kann z. B. für einen verbesserten Anschluß an einen externen Wellenleiter vorgesehen sein.

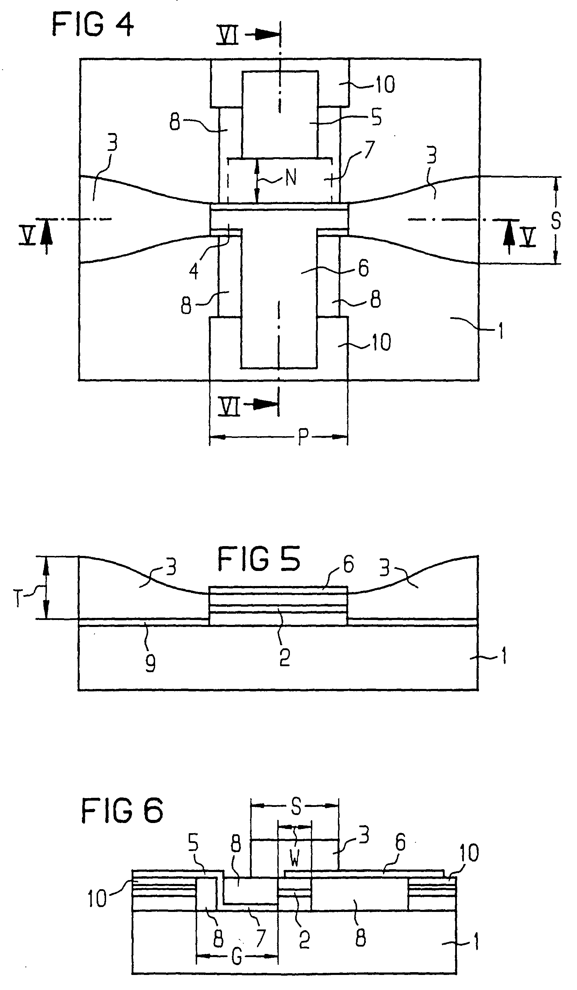

Bei dem alternativen Ausführungsbeispiel der Figur 4 sind von der für das Bauelement 4 aufgewachsenen Schichtstruktur Anteile, die in diesem Beispiel mit einer Isolationsschicht 10 bedeckt sind, im Abstand von dem Bauelement stehengelassen worden. Es genügt daher, wenn die Dielektrikumschicht 8 nur im Bereich zwischen dem Bauelement und diesen restlichen Anteilen aufgebracht wird. Die Wellenleiter 3 sind in diesem Beispiel als Taper ausgeführt. Sowohl senkrecht zur Oberseite des Substrates 1 als auch in der Ebene dieser Oberseite verbreitern sich die Wellenleiter zum Rand des Substrates hin. Die Verbreiterung der Wellenleiter kann statt dessen ausschließlich in der Ebene der Substratoberfläche oder ausschließlich senkrecht zu dieser Oberseite vorhanden sein.

In Figur 5 ist der in Figur 4 eingezeichnete Querschnitt dargestellt. Zwischen dem Substrat 1 und den Wellenleitern 3 ist wieder eine für die Wellenführung vorgesehene zusätzliche Schicht 9 vorhanden, die auch hier weggelassen sein kann. Von der Höhe des Bauelementes vergrößert sich die vertikale Abmessung des Wellenleiters 3 bis zu dem größten Wert T am Rand des Substrates. Diese Höhe T der taperartigen Verbreiterung der Wellenleiter beträgt z. B. zwischen 2 µm und 12 µm.

In Figur 6 ist der andere in Figur 4 eingezeichnete Querschnitt dargestellt. Zwischen den Kontakten 5, 6 und den restlichen Anteilen der für das Bauelement vorgesehenen Schichtfolge ist jeweils eine Isolationsschicht 10 vorhanden. Der Wellenleiter 3 weist in Blickrichtung die eingezeichnete rechteckige Kontur auf. Die Breite W des Bauelementes beträgt auch hier z. B. zwischen 0,1 µm und 4 µm. Die maximale Breite S des Wellenleitertapers beträgt vorzugsweise zwischen 0,1 µm und 12 µm. Die Abmessungen der Dielektrikumschicht 8 zwischen den Anteilen der epitaktisch gewachsenen Schichtstruktur, in Figur 6 als Abstand G eingezeichnet, beträgt z. B. zwischen 10 µm und 200 µm. Die Abmessung N des unteren Anteils 7 des Kontaktes 5 beträgt auch hier vorzugsweise etwa 10 µm bis 20 µm. Die seitliche Abmessung P der restlichen Anteile der Schichtfolge, auf denen die Kontakte aufgebracht sind, beträgt z. B. 50 µm bis 600 µm.

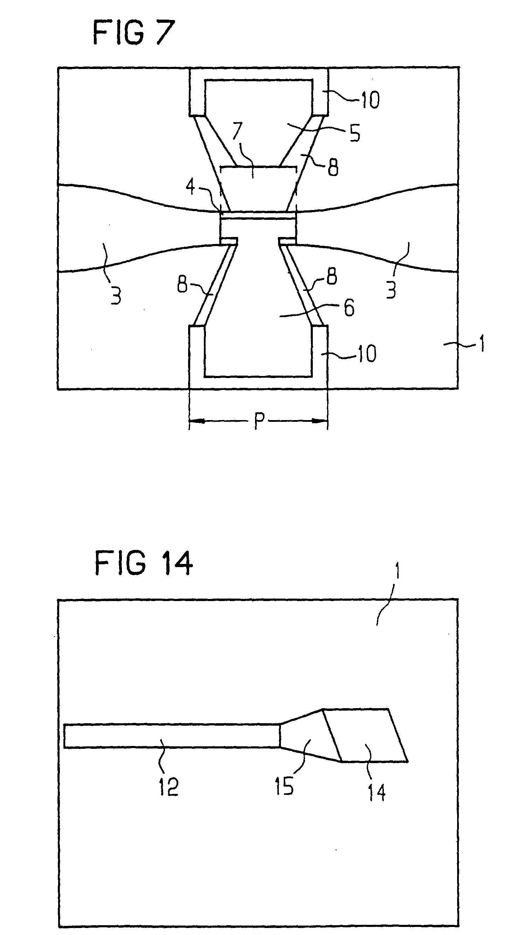

Bei der Ausführungsform der Figur 7 ist die Abmessung P größer als die Länge des Bauelementes. Die Kontakte 5, 6 und die Schichten aus Dielektrikum 8 verjüngen sich in Richtung zum Bauelement 4 hin. Man erhält so auch bei kleinen Bauelementen große Anschlußflächen für die Kontakte 5, 6.

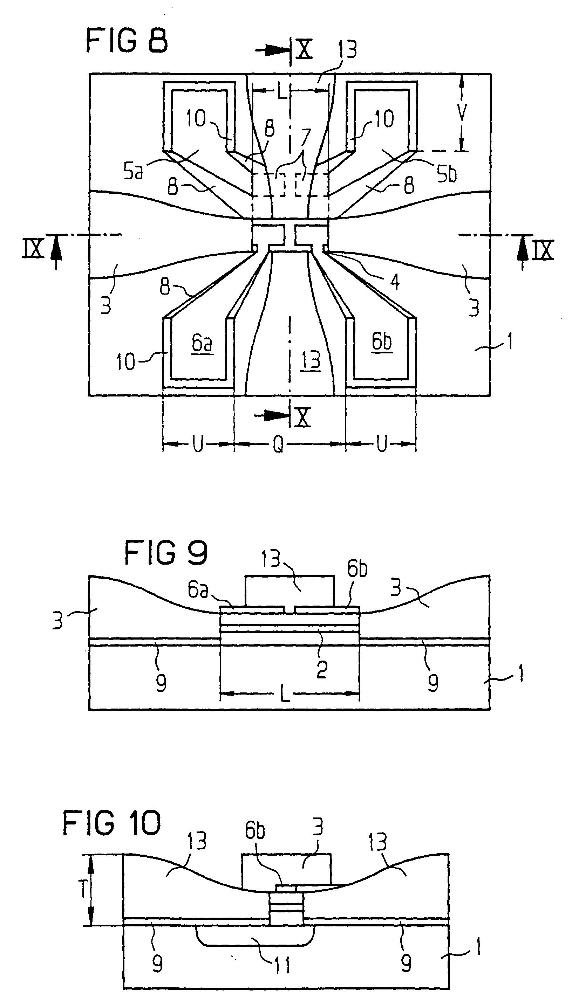

Bei dem Ausführungsbeispiel der Figur 8 sind auch quer zur Längsrichtung des Bauelementes 4 passive Wellenleiter 13 an die Wellenleiterschicht 2 des Bauelementes angeschlossen. Die Anordnung der Wellenleiter 3, 13 in bezug auf das Bauelement 4 ist hier symmetrisch gewählt. Die Kontakte 5a, 5b, 6a, 6b sind hier jeweils zweiteilig ausgebildet. Sie sind teilweise auf restlichen Anteilen der gewachsenen Schichtfolge und davon durch eine Isolationsschicht 10 getrennt und teilweise auf einer Dielektrikumschicht 8 aufgebracht. Beide Anteile eines Kontaktes 5a, 5b sind nach unten zur Unterseite des Bauelementes auf die Oberseite des Substrates geführt. Diese unteren Anteile 7 sind hier aber als Beispiel in einem geringen Abstand zu dem Bauelement angeordnet. Die elektrisch leitende Verbindung zu dem Bauelement wird hier z. B. dadurch hergestellt, daß in der Oberseite des Substrates ein elektrisch leitend dotierter Bereich ausgebildet ist, über den die unteren Anteile 7 der Kontakte 5a, 5b mit einer untersten Schicht des Bauelementes 4 elektrisch leitend verbunden sind. Der auf der Oberseite des Bauelementes aufgebrachte Kontakt 6a, 6b ist hier ebenfalls zweiteilig ausgeführt und teilweise auf einer Isolationsschicht 10 über Resten der Schichtfolge und teilweise auf einer Dielektrikumschicht 8 aufgebracht.

Figur 9 zeigt den in Figur 8 eingezeichneten Querschnitt, in dem die beiden getrennten Anteile des Kontaktes 6a, 6b auf der Oberseite des Bauelementes erkennbar sind. Die übrigen Komponenten entsprechen denjenigen in dem Ausführungsbeispiel der Figur 5. Figur 10 zeigt den anderen in Figur 8 eingezeichneten Querschnitt, in dem in der Blickrichtung der eine Kontakt 6b auf der Oberseite des Bauelementes und die äußere Kontur des Wellenleitertapers 3 erkennbar sind. In dem Substrat ist ein dotierter Bereich 11 eingezeichnet, der für den beschriebenen elektrischen Anschluß zwischen den Anteilen 7 des Kontaktes 5a, 5b und dem Bauelement vorgesehen ist. Bei Vorhandensein der eingezeichneten Schicht 9, die die Wellenführung zum Substrat hin verbessern soll, ist diese Schicht entweder elektrisch leitend ausgebildet oder zwischen den Anteilen 7 des Kontaktes und dem dotierten Bereich 11 weggelassen.

Die in den Figuren 8 bis 10 eingezeichneten Abmessungen sind wie folgt:
Länge L des Bauelementes z. B. zwischen 1 µm und 600 µm,
die Abmessungen U und V der restlichen Schichtanteile z. B. 50 µm bis 200 µm,
maximale Höhe T der Wellenleitertaper z. B. zwischen 2 µm und 12 µm und
der Abstand Q zwischen den Resten der epitaktisch gewachsenen Schichten, auf denen jeweils die beiden Anteile eines Kontaktes aufgebracht sind, z. B. höchstens 100 µm.

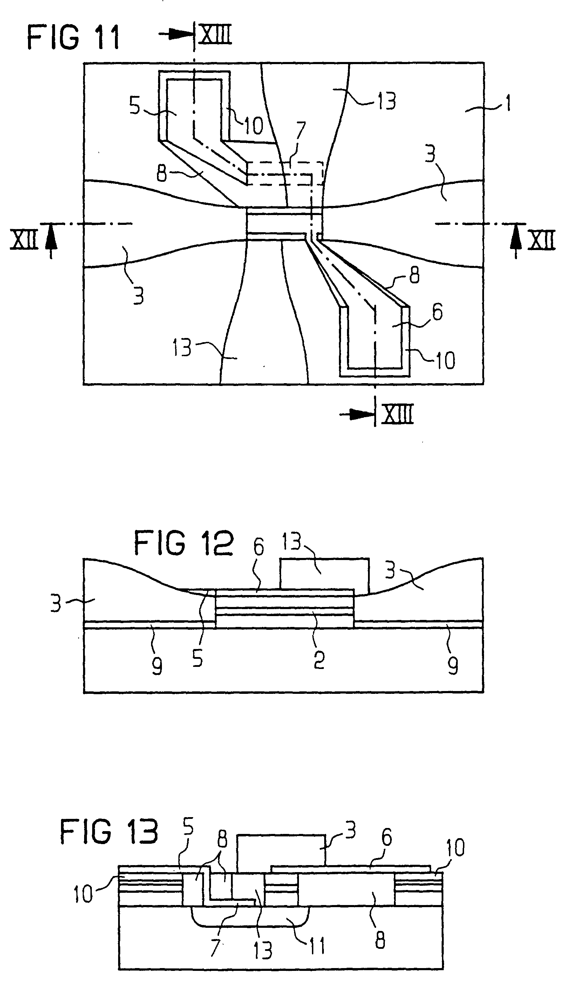

Bei dem Ausführungsbeispiel der Figur 11 sind die zusätzlichen Wellenleiter 13 gegeneinander in Längsrichtung des Bauelementes versetzt. Die Kontakte 5, 6 sind hier einteilig und mit in Längsrichtung des Bauelementes zueinander versetzten Anschlußflächen aufgebracht. Figur 12 und Figur 13 zeigen die in Figur 11 eingezeichneten Querschnitte, wobei die in der Blickrichtung senkrecht zu den eingezeichneten Schnittlinien erkennbaren Teile jeweils mit eingezeichnet wurden. So sind in Figur 12 ein kurzes Stück des Kontaktes 5 und die Kontur des Wellenleitertapers 13 in der Blickrichtung erkennbar. Wegen der mehrfachen Richtungsänderung der Schnittlinie des Querschnittes der Figur 13 ist in Figur 11 oben eingezeichnete passive Wellenleiter 13 in dem Querschnitt der Figur 13 der Übersichtlichkeit wegen weggelassen. Die in Figur 13 dargestellte Ansicht entspricht daher einem Ausführungsbeispiel, bei dem sich der Wellenleiter 13 nach außen hin nur in der Ebene der Oberseite des Substrates verbreitert, nicht aber senkrecht dazu. Die Dielektrikumschicht 8 deckt den unteren Anteil 7 des Kontaktes 5 teilweise ab. Der Rest des unteren Anteils 7 des Kontaktes 5, der sich unter dem Wellenleiter 13 leiter 13 befindet, wird nur von dem Wellenleiter 13 bedeckt, wie in Figur 13 erkennbar ist.

In Figur 14 ist ein Ausführungsbeispiel des erfindungsgemäßen Moduls dargestellt, bei dem zwei verschiedene aktive Bauelemente 12, 14 durch einen passiven Wellenleiter 15 aus einem anderen Material miteinander verbunden sind. Das Bauelement 12 kann z. B. eine Laserdiode, das Bauelement 14 eine Fotodiode sein. Die unterschiedlichen Abmessungen der in den Bauelementen vorhandenen Wellenleiterschichten wird durch einen taperförmigen passiven Wellenleiter 15 ausgeglichen.

Die erfindungsgemäßen Module sind für den Einsatz bei hybrider Integration mit passiven Wellenleitern oder Netzwerken besonders vorteilhaft, da auf eine aufwendige Justierung der Komponenten verzichtet werden kann und nur eine einfache Plazierung notwendig ist (Pick- and -place-Technik).

## Patentansprüche

1. Optoelektronischer Modul
- auf einem Substrat (1) aus Halbleitermaterial, auf dem mindestens
- ein optoelektronisches Bauelement (4) und
- ein passiver Wellenleiter (3, 13) angeordnet sind,
- bei dem das Bauelement in einer auf das Substrat epitaktisch gewachsenen Schichtfolge ausgebildet ist,
- bei dem diese Schichtfolge durch Schichten aus Halbleitermaterial oder aus Mischkristallzusammensetzungen eines oder mehrerer Halbleitermaterialien gebildet ist,
- bei dem der passive Wellenleiter als integrierter Bestandteil des Moduls auf dem Substrat aufgebracht und so angeordnet ist, daß er Strahlung von oder zu einem Bereich (2) des optoelektronischen Bauelementes zu oder von einer für externe Ankopplung vorgesehenen Anschlußfläche führt, und
- bei dem der passive Wellenleiter durch Material gebildet ist, das aus einer oder mehreren Komponenten gebildet ist, die sämtlich von jedem Halbleitermaterial in dem optoelektronischen Bauelement verschieden sind,
**dadurch gekennzeichnet, daß**
mindestens zwei voneinander getrennte optoelektronische Bauelemente (12, 14) in auf das Substrat epitaktisch gewachsenen Schichtfolgen ausgebildet sind und
der passive Wellenleiter (15) durch Material gebildet ist, das aus einer oder mehreren Komponenten gebildet ist, die sämtlich von jedem Halbleitermaterial in den optoelektronischen Bauelementen verschieden sind, und
der passive Wellenleiter Bereiche in diesen optoelektronischen Bauelementen miteinander verbindet.

2. Modul nach Anspruch 1,
- bei dem mindestens ein erster Kontakt (6; 6a, 6b) auf einer von dem Substrat (1) abgewandten Oberseite eines Bauelementes (4) und seitlich bezüglich der Längsrichtung des Bauelementes (4) auf einer Dielektrikumschicht (8) aufgebracht ist und
- bei dem mindestens ein mit einer untersten Schicht des Bauelementes elektrisch leitend verbundener zweiter Kontakt (5; 5a, 5b) mit einem seitlich bezüglich der Längsrichtung des Bauelementes (4) angeordneten unteren Anteil (7) und einem auf einer Dielektrikumschicht (8) aufgebrachten Anteil vorhanden ist.

3. Modul nach Anspruch 1 oder 2,
bei dem ein Anteil des ersten Kontaktes (6; 6a, 6b) und/oder ein Anteil des zweiten Kontaktes (5; 5a, 5b) auf einer Isolationsschicht (10) angeordnet ist bzw. sind, die auf mindestens einem restlichen, von dem Bauelement (4) getrennten Anteil der epitaktisch gewachsenen Schichtfolge aufgebracht ist.

4. Modul nach einem der Ansprüche 1 bis 3,
bei dem zwischen dem passiven Wellenleiter (3, 13) und dem Substrat (1) eine die Wellenführung verbessernde reflektierende Schicht (9) oder Schichtstruktur angeordnet ist.

5. Modul nach einem der Ansprüche 1 bis 4,
bei dem mehrere passive Wellenleiter vorhanden sind,
bei dem jeder passive Wellenleiter durch Material gebildet ist, das aus einer oder mehreren Komponenten gebildet ist, die sämtlich von jedem Halbleitermaterial in dem optoelektronischen Bauelement bzw. in den optoelektronischen Bauelementen verschieden sind, und
bei dem mindestens zwei passive Wellenleiter zu demselben optoelektronischen Bauelement geführt sind.

6. Modul nach einem der Ansprüche 1 bis 5,
bei dem der passive Wellenleiter Polyimid ist.

7. Modul nach einem der Ansprüche 1 bis 5,
bei dem der passive Wellenleiter Bisbenzocyclobuten ist.

## Claims

1. Optoelectronic module
- on a substrate (1) made of semiconductor material, on which at least
- an optoelectronic component (4) and
- a passive waveguide (3, 13) are arranged,
- in which the component is formed in a layer sequence grown epitaxially on the substrate,
- in which this layer sequence is formed by layers made of semiconductor material or made of solid-solution compositions of one or more semiconductor materials,
- in which the passive waveguide is applied as an integrated constituent part of the module on the substrate and is arranged in such a way that it guides radiation from or to a region (2) of the optoelectronic component to or from a connection area provided for external coupling, and
- in which the passive waveguide is formed by material which is formed from one or more components which all differ from every semiconductor material in the optoelectronic component,
**characterized in that**
at least two mutually separate optoelectronic components (12, 14) are formed in layer sequences grown epitaxially on the substrate, and
the passive waveguide (15) is formed by material which is formed from one or more components which all differ from every semiconductor material in the optoelectronic components, and
the passive waveguide connects regions in these optoelectronic components to one another.

2. Module according to Claim 1,
- in which at least one first contact (6; 6a, 6b). is applied on a top side - remote from the substrate (1) - of a component (4) and laterally with respect to the longitudinal direction of the component (4) on a dielectric layer (8), and
- in which at least one second contact (5; 5a, 5b) electrically conductively connected to a lowermost layer of the component is present, with a lower portion (7) arranged laterally with respect to the longitudinal direction of the component (4), and a portion applied on a dielectric layer (8).

3. Module according to Claim 1 or 2,
in which a portion of the first contact (6; 6a, 6b) and/or a portion of the second contact (5; 5a, 5b) is or are arranged on an insulation layer (10), which is applied on at least one residual portion of the epitaxially grown layer sequence, the said portion being isolated from the component (4).

4. Module according to one of Claims 1 to 3,
in which a reflective layer (9) or layer structure which improves the wave guidance is arranged between the passive waveguide (3, 13) and the substrate (1).

5. Module according to one of Claims 1 to 4,
in which a plurality of passive waveguides are present,
in which each passive waveguide is formed by material which is formed from one or more components which all differ from every semiconductor material in the optoelectronic component or in the optoelectronic components, and
in which at least two passive waveguides are routed to the same optoelectronic component.

6. Module according to one of Claims 1 to 5,
in which the passive waveguide is polyimide.

7. Module according to one of Claims 1 to 5,
in which the passive waveguide is bisbenzocyclobutene.

## Revendications

1. Module optoélectronique
- sur un substrat (1) en matériau semi-conducteur, sur lequel sont disposés au moins
- un composant (4) optoélectronique et
- un guide d'ondes (3, 13) passif,
- dans lequel le composant est constitué d'une succession de couches obtenues par croissance par épitaxie sur le substrat,
- dans lequel cette succession de couches est formée de couches en matériau semi-conducteur ou en compositions de cristal mixte d'un matériau semi-conducteur ou de plusieurs matériaux semi-conducteurs,
- dans lequel le guide d'ondes passif est déposé en tant que constituant intégré du module sur le substrat et est disposé de façon à faire passer du rayonnement d'une partie (2) du composant optoélectronique à une surface de raccordement prévue pour un couplage extérieur ou d'une surface de raccordement prévue pour un raccordement extérieur à une partie du composant optoélectronique et
- dans lequel le guide d'ondes passif est constitué en matériau qui est formé d'un constituant ou de plusieurs constituants qui dans l'ensemble sont différents de chaque matériau semi-conducteur du composant optoélectronique,
**caractérisé en ce que**,
au moins deux composants (12, 14) optoélectroniques séparés l'un de l'autre sont constitués dans des successions de couches obtenues par croissance par épitaxie sur le substrat et
le guide d'ondes (15) passif est en un matériau formé d'un ou de plusieurs constituants qui ensemble sont différents de chaque matériau semi-conducteur des composants optoélectroniques et
les parties passives de guide d'ondes de ces composants optoélectroniques sont reliées entre elles.

2. Module suivant la revendication 1,
- dans lequel au moins un premier contact (6 ; 6a, 6b) est déposé sur une face supérieure, qui est éloignée du substrat (1), d'un composant (4) et latéralement par rapport à la direction longitudinale du composant (4) sur une couche (8) de diélectrique et
- dans lequel il est prévu au moins un deuxième contact (5 ; 5a, 5b) qui est relié d'une manière conductrice de l'électricité à la couche la plus basse du composant, qui a une partie (7) inférieure disposée latéralement par rapport à la direction longitudinale du composant (4) et une partie déposée sur une couche (8) diélectrique.

3. Module suivant la revendication 1 ou 2,
dans lequel une partie du premier contact (6 ; 6a, 6b) et/ou une partie du deuxième contact (5 ; 5a, 5b) est ou sont disposées sur une couche (10) d'isolement qui est déposée sur au moins une partie restante de la succession de couches que l'on a fait croître par épitaxie, cette partie étant séparée du composant (4).

4. Module suivant l'une des revendications 1 à 3,
dans lequel il est prévu entre le conducteur d'ondes (3, 13) passif et le substrat (1) une couche (9) ou une structure stratifiée réfléchissante améliorant le passage des ondes.

5. Module suivant l'une des revendications 1 à 4,
dans lequel il est prévu plusieurs guides d'ondes passifs,
dans lequel chaque guide d'ondes passif est formé de matériau constitué d'un ou de plusieurs constituants, qui ensemble sont différents de chaque matériau semi-conducteur du composant optoélectronique ou des composants optoélectroniques, et
dans lequel au moins deux guides d'ondes passifs vont vers le même composant optoélectronique.

6. Module suivant l'une des revendications 1 à 5,
dans lequel le guide d'ondes passif est en polyimide.

7. Module suivant l'une des revendications 1 à 5,
dans lequel le guide d'ondes passif est en bisbenzocyclobutène.
